Europäisches Patentamt

European Patent Office

Office européen des brevets

(11) Publication number: **0 132 972**
**B1**

## (12) EUROPEAN PATENT SPECIFICATION

(45) Date of publication of patent specification: **11.10.89**

(21) Application number: **84304603.8**

(22) Date of filing: **05.07.84**

(51) Int. Cl.⁴: **B 41 J 3/04**

(54) A charge electrode structure for ink jet printers, and a method of fabricating the same.

(30) Priority: **27.07.83 US 517608**

(43) Date of publication of application:
**13.02.85 Bulletin 85/07**

(45) Publication of the grant of the patent:
**11.10.89 Bulletin 89/41**

(84) Designated Contracting States:
**DE FR GB NL**

(56) References cited:
**US-A-3 397 345**
**US-A-3 618 858**
**US-A-4 101 906**
**US-A-4 223 320**

(73) Proprietor: **EASTMAN KODAK COMPANY (a New Jersey corporation)**
**343 State Street**
**Rochester New York 14650 (US)**

(72) Inventor: **Schutrum, Walter Louis**
**4663 Parklawn Drive**
**Kettering Ohio 45440 (US)**

(74) Representative: **Warren, Anthony Robert et al**
**BARON & WARREN 18 South End Kensington London W8 5BU (GB)**

Courier Press, Leamington Spa, England.

## Description

The present invention relates generally to ink jet printing systems and, more particularly, to a molded charge electrode structure or charge plate and method of fabricating the charge plate for use in an ink jet printing system.

In ink jet printers, tiny ink drops are selectively deposited onto a medium, typically a moving web or sheet to form a printed image. The ink drops are formed from liquid filaments emerging from tiny openings in an orifice plate communicating with an ink reservoir containing pressurized electrically conductive ink. By mechanically stimulating the orifice plate, uniformly sized and spaced drops are forced to break off from the fluid filaments.

As each drop separates from its associated fluid filament, it is permitted to remain uncharged or is selectively charged to one or more charge levels by an associated charge electrode. The drops then pass through an electrical deflection field.

Printing is performed in a variety of ways. For example, charged drops can be deflected by the deflection field to a drop catcher and uncharged drops which are not deflected by the field continue past the catcher to form the printed images, for example, on a moving web of material. Alternatively, the uncharged drops may be caught with the charged drops being deflected to one or a variety of positions on the moving web dependent upon the charge level of the particular drop. In any event, the importance of the charge electrode structure to proper operation of an ink jet printer is clearly evident.

Typical prior art charge electrodes have been formed by coating electrically conductive material onto a nonconductive substrate. Many prior art charge electrodes have partially or wholly surrounded the corresponding ink jet stream and normally extend uniformly along the stream for a distance of at least several drop diameters. Due to the tendency of the ink drops to separate from the filaments at different points, the electric field produced by a charge electrode must be uniform along the length of the ink filaments so that drops are properly charged regardless of their exact point of separation.

Early patents to Loughren, U.S. Patent No. 3,404,221 and Sweet et al., U.S. Patent No. 3,373,437, utilized cylindrically shaped tubular electrodes to completely surround the ink jet stream or U-shaped channel electrodes to partially surround the stream. Unfortunately, accurate placement of the tubes or channels into a support structure and electrical connection of such electrodes to a signal source are both difficult and time consuming. Such placement and connection problems increase as the spacing between electrodes is reduced in multiple jet systems utilizing hundreds of individual streams of ink drops spaced within a few thousandths of an inch of one another. Also, as the spacing between adjacent electrodes is reduced, the tube or channel walls become extremely thin. Thin electrode walls reduce reliability and, at some point, preclude formation of such electrodes.

Various attempts have been made to reduce the difficulty and expense of forming charge electrodes. For example, Beam et al., U.S. Patent No. 3,586,907, shows a charge ring plate wherein a series of holes have an electrically conductive coating surrounding each hole and extending along the walls to form the charge electrodes. Electrical lead lines are plated onto the surface of the charge plate and extend from each charge ring to a connection point. The techniques involved in plating the walls of the holes to obtain a continuous and uniform coating are complex and involve plating in several dimensions. Similarly, coating the U-shaped channel shown in Culp, U.S. Patent No. 3,618,858, with an electrically conductive material also involves plating in several dimensions.

Robertson, U.S. Patent Nos. 3,604,980 and 3,656,171, disclose charge electrodes formed by a series of strips of electrically conductive material plated onto a dielectric planar surface with each strip connected to a charging signal source.

Kenworthy, U.S. Patent No. 4,223,321, discloses a planar charge plate wherein grooves are cut into the edge of a nonconductive substrate with the grooves and lands being metalized and printed circuit paths formed leading from the grooves. The grooves are then filled with an electrically conductive material, such as solder, and the front face of the structure is lapped to remove excess solder and metal plating from the lands to form the charge plate.

The charge electrodes of Robertson and Kenworthy differ from other prior art charge electrodes in that they do not surround or partially surround the drop streams. However, the formation of Robertson's conductive strips still requires plating in several dimensions and Kenworthy requires accurate machining initially to form the grooves in the substrate.

Bahl and Schutrum, U.S. Patent No. 4,347,522, discloses a method of forming charge electrodes by laminating a plurality of thin sheets of electrically conductive material to construct essentially any form of electrode.

While charge electrodes manufactured in accordance with the teachings of a variety of the prior art provide satisfactory operation of ink jet printers and have typically provided somewhat reduced costs as the art has advanced, more simplified methods for producing reliable charge electrode structures at still further reduced costs are always needed and desirable for advances and improvements in the ink jet art.

The invention provides a novel molded charge electrode structure or charge plate and a method of fabricating such a charge plate for use in an ink jet printer.

According to one aspect of the present invention, there is provided a charge electrode structure comprising a dielectric substrate, a plurality of regularly spaced electrodes exposed at a first surface of said substrate and a plurality of electrically conducting circuit paths disposed in a second surface of said substrate adjacent to said first surface, said circuit paths being electrically connected to said electrodes, characterised in that both said regularly spaced electrodes and said electrically conducting circuit paths are embedded within the respective first and second surfaces of said substrate.

The electrodes and circuit paths preferably include retaining means extending beyond their generally parallel sidewalls at the innermost extensions of the electrodes and circuit paths to anchor the electrodes and circuit paths into the dielectric substrate. The retaining means comprise expansions of the electrodes and circuit paths to form retaining flanges which, when viewed from the end, resemble the caps of mushrooms or the heads of nails. The retaining flanges securely engage the dielectric substrate to prevent withdrawal of the embedded electrodes and conducting paths from the substrate.

Preferably, the dielectric substrate comprises an epoxy resin or other dielectric material which may be readily molded to completely surround the electrodes and circuit paths including the generally parallel sidewalls as well as the retaining flanges of the electrodes and circuit paths. To reduce the volume of epoxy resin required to form a given substrate, sheet means, for example, a perforated sheet of fiberglass epoxy board may be placed over the electrodes prior to molding the substrate. A reduction of the volume of epoxy resin required reduces shrinkage of the epoxy resin during curing. Further, the sheet of fiberglass epoxy board can be covered with a conductive material or replaced by a perforated sheet of stainless steel either of which are connected to a selected potential to reduce signal interference or cross-talk between the electrodes and circuit paths.

The charge plate structure of the present invention provides a rugged, high reliability charge plate having high dimensional accuracy and excellent electrical characteristics which is relatively inexpensive and readily fabricated in accordance with the method of the present invention by means of highly accurate photolithographic, plating and molding techniques without any requirement for high precision machining operations.

In a method of fabricating a charge plate in accordance with the present invention, a pattern defining electrode and associated connecting circuit path positions is formed onto a substantially planar foil sheet with the remainder of the sheet being protected by a covering which is resistant to plating operations. Preferably, the foil sheet is copper and the pattern is formed by initially laminating a photoresistive film covering to the foil sheet, exposing the photoresistive covering to actinic light through a photomask to define the electrode and circuit path pattern and removing the portion of the covering corresponding to the pattern to expose the surface of the copper foil thereunder.

The exposed pattern is then plated with an electrically conducting material, preferably nickel, to form electrodes and the associated connecting circuit paths. The electrodes and associated circuit paths are preferably formed to a thickness which exceeds the thickness of the photoresistive covering. By plating to a thickness beyond that of the photoresistive covering, the plated material extends above and expands over the upper surface of the covering to form retaining flanges on each of the electrodes and circuit paths. The plating operation is limited such that no two of the flanges interconnect with one another. The remainder of the photoresistive covering is then thoroughly removed from the foil sheet such that the electrodes and the connecting circuit paths with their retaining flanges extend above the surface of the foil sheet.

The foil sheet is then bent toward the plated material with at least a portion of the electrodes being bent and angularly oriented, preferably at approximately a 90° angle, relative to the circuit paths. The bent portion of the foil sheet including at least a portion of the electrodes will define the charge face of the finally formed charge plate.

A dielectric substrate is then formed to surround the plated material including the retaining flanges. The substrate is formed to have two surfaces covered by said foil sheet which is then removed to expose the plated material electrodes and circuit paths embedded within the substrate and preferably anchored thereto by means of retaining flanges.

Preferably, the bent foil sheet is clamped into a mold with the portion of the sheet including the connecting circuit paths being clamped to the mold as well as the bent portion of the sheet to ensure flatness of those portions of the substrate after formation. The dielectric substrate is then formed by inserting molding material, such as an epoxy resin, into the mold and curing the molding material to form the dielectric substrate.

A perforated sheet of fiberglass epoxy board can be inserted into the mold to displace some of the epoxy resin and thereby reduce shrinkage of the epoxy resins during curing. The fiberglass sheet may be covered with an electrically conductive coating which is connected to a selected potential, typically ground, to reduce potential interference or cross-talk between signals on the electrodes and circuit paths. Alternately, the fiberglass sheet can be replaced by a perforated sheet of stainless steel which is connected to a selected potential to both reduce required epoxy volume and reduce interference. Either fiberglass epoxy sheets or stainless steel sheets also serve to strengthen the substrate and, hence, the charge plate of the present invention.

It is, therefore, an object of the present invention to provide a molded charge plate wherein the electrodes and connecting circuit paths are embedded within a dielectric substrate with the electrodes and circuit paths being anchored into the substrate by means of retaining flanges formed at their innermost ends with the molded charge plate being advantageously fabricated by means of highly accurate and easily performed photographic, plating and molding operations.

Other objects and advantages of the invention will be apparent from the following description, the accompanying drawings and the appended claims.

In order that the invention may be more readily understood, reference will now be made to the accompanying drawings, in which:

Fig. 1 is a perspective view of a patterned foil sheet ready to be plated.

Fig. 2 is a cross-section through the electrode portion of the pattern shown on Fig. 1 along the section line 2-2.

Fig. 2A illustrates the cross-section of Fig. 2 immediately after electrodes have been plated thereon.

Fig. 3 is a perspective view of a foil sheet having plated electrodes and connecting circuit paths formed thereon.

Fig. 4 is a cross-sectional view through the plated electrodes and foil sheet of Fig. 3 along the section line 4-4.

Fig. 5 shows the composite foil sheet/plating of Fig. 3 having the electrode end bent toward the plated material.

Fig. 6 is a perspective view of an illustrative mold including the bent composite of Fig. 5 together with a clamp arrangement for clamping the bent portion of the composite to a sidewall of the mold (see drawing sheet 4).

Fig. 7 is a plan view of the mold of Fig. 6 with the clamp arrangement secured to the mold.

Fig. 8 is a cross-sectional view through the mold of Fig. 6 along the section line 8-8.

Fig. 9 is a fragmentary sectional view of a small portion of a foil sheet and three electrodes or circuit paths embedded within a dielectric substrate.

Fig. 10 is the same as Fig. 9, except the foil sheet has been removed to expose the electrodes or circuit paths and intervening surface areas of the dielectric substrate.

Fig. 11 is a perspective view of a molded charge electrode structure having embedded and anchored electrodes and connecting circuit paths in accordance with the present invention (see drawing sheet 3).

The present invention will now be described by initially describing the method of fabrication of the molded charge electrode structure. After the method of fabrication is fully understood, the novel structure of the molded charge plate will be more clear. —

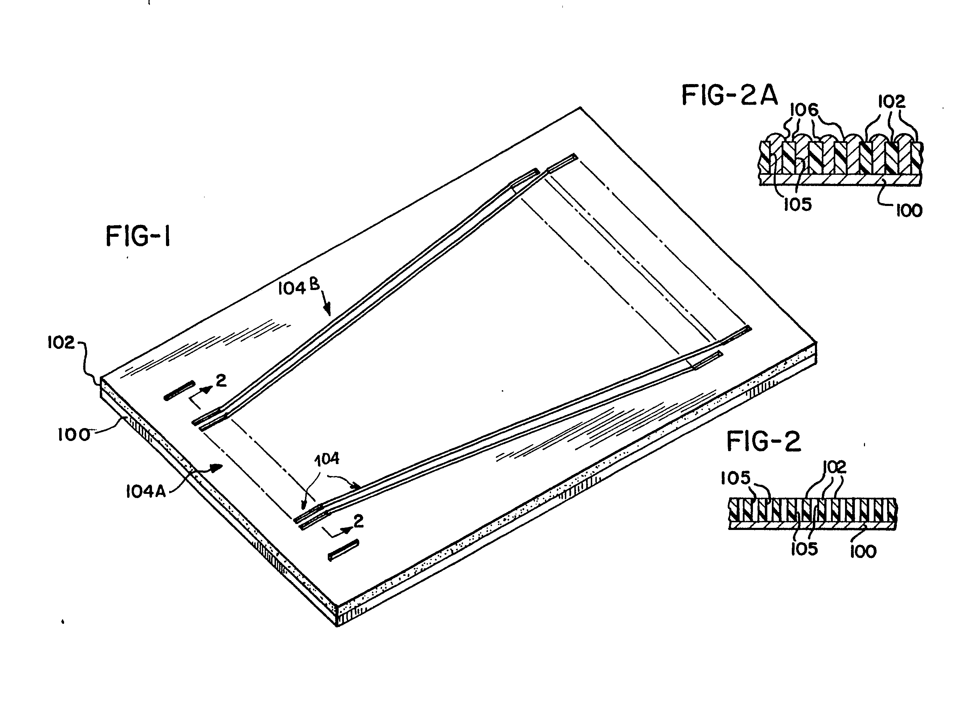

Fig. 1 shows a foil sheet 100 with a photoresistive covering 102 on its upper surface. One fabrication of an operable charge plate in accordance with the present invention, utilized electrodeposited (ED) copper foil having a thickness of 1.4 mils (0.0014 inches) which was laminated with one layer of photopolymer film resist commercially available from Dupont as Type 218R, to form a photoresistive covering 1.8 mils (0.0018 inches) thick. The photoresistive material was then selectively exposed through a photomask to actinic light (ultraviolet light of a wavelength of 300 to 400 nanometers for the identified photoresistive material).

For the identified photoresistive material, the photomask is in the positive mode which prevents light from striking the electrode and conducting path pattern 104 shown in Fig. 1. Photoresistive material exposed to the actinic light is polymerized. After exposure, an aqueous alkaline solution is utilized to develop or wash away the nonpolymerized areas of the covering corresponding to the electrode and connecting circuit path pattern 104. The pattern 104 thus prepared defines the locations or positions for the formation of electrodes and connecting circuit paths on the foil sheet 100.

It should be noted that a variety of foils and foil thicknesses may be combined with various thicknesses of a variety of photoresistive materials and processed in accordance with well known techniques to form a patterned foil sheet as shown in Fig. 1. In particular, the depth of the photoresistive covering determines the embedded depth of the electrodes and circuit paths as will become clear. While such well known materials and techniques will not be further described herein, it should be noted that any combination of these known techniques and materials may be utilized in the present invention.

Fig. 2 shows a sectional view taken through the electrode portion 104A of the pattern 104 showing that the photoresistive material 102 corresponding to the pattern 104 has been removed down to the copper foil 100. The remaining areas of the polymerized photoresistive covering 102, as shown in Fig. 2, serve as a resistant barrier to plating operations which are utilized to form the electrodes and connecting circuit paths of the molded charge electrode structure on the foil sheet 100.

The patterned laminated foil sheet of Fig. 1 is preferably placed into a plating bath although any appropriate plating technique can be employed in accordance with the present invention. In the plating bath, an electrically conducting material, preferably nickel, is plated to the foil sheet 100 through the openings in the photoresistive material 102 which define the pattern 104. The plating operation is controlled such that the thickness of the plating exceeds the thickness of the photoresistive material 102 by approximately 0.2 mils (0.0002 inches). For example, the current density and plating time is controlled for electrolytic plating.

As the plating material extends above the parallel sidewalls 105 of the photoresistive material 102 defining the pattern 104 (see Fig. 2A), the plating material overplates the photoresistive material to spread beyond the limitations defined by the sidewalls 105 and thereby form retaining flanges 106. The retaining flanges 106 appear in cross-section as the heads of nails or the tops of mushrooms. The plating operation is limited such that the retaining flanges 106 formed on the upward ends of the plated material electrodes and connecting circuit paths extend beyond the sidewalls 105 but not to such an extent that they contact adjacent retaining flanges.

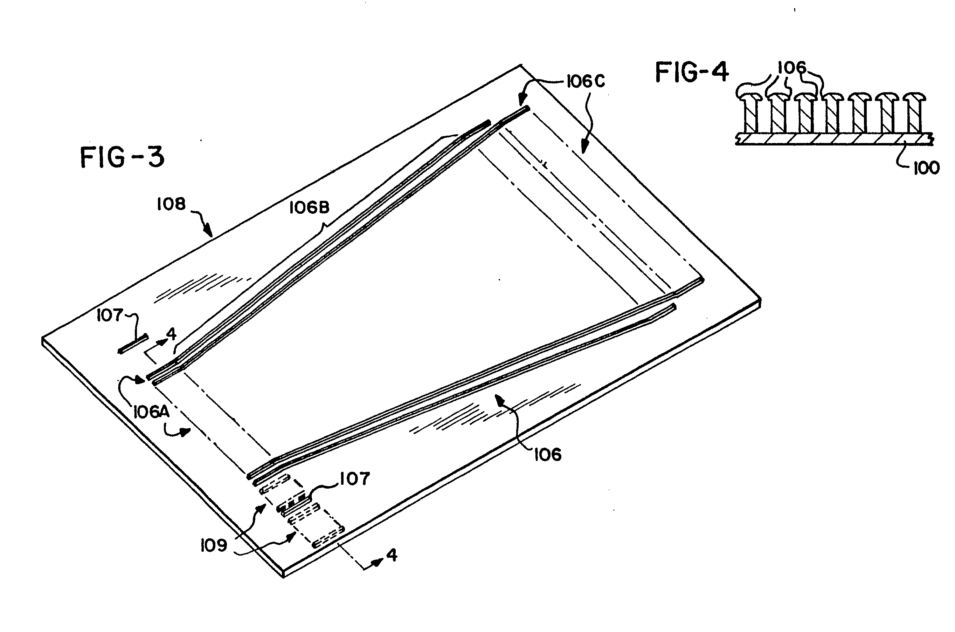

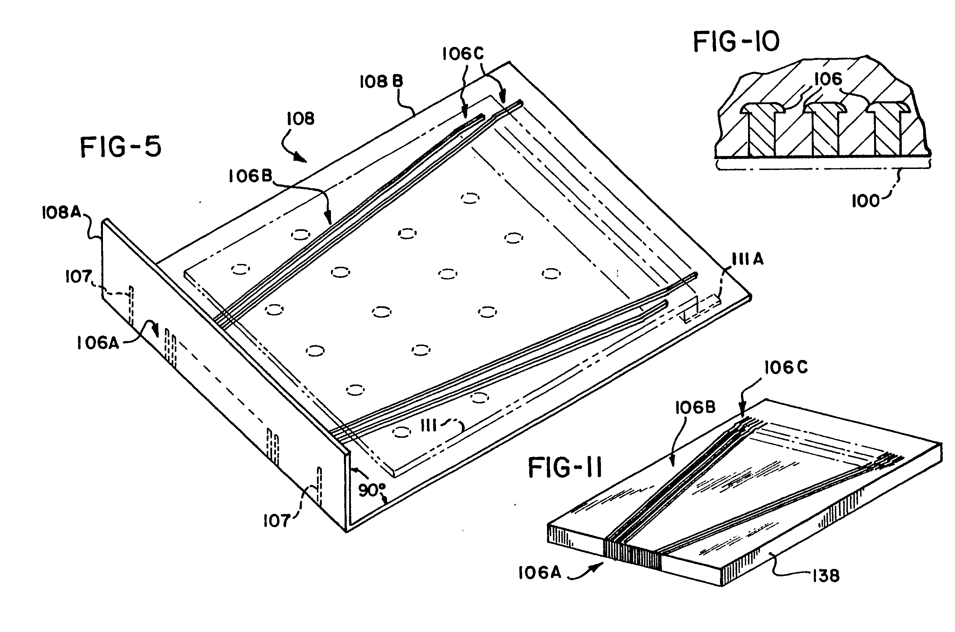

The remaining polymerized photoresistive material is next removed by a mixture of dimethyl chloride and 3% methyl alcohol. The cleaning procedure must be thoroughly performed to ensure removal of the photoresist from beneath the edges of the retaining flanges 106 such that the electrodes and connecting circuit paths cleanly extend above the foil sheet 100 as shown in Fig. 4. Cleaning results in a composite foil sheet/plating 108 comprising the foil sheet 100 with plated electrodes and connecting circuit paths 106B electroformed in the positions defined by the pattern 104 and extending above the surface of the foil sheet 100 as shown in Fig. 3. One or more alignment pins 107 can also be formed by means of the plating operation to facilitate alignment of the molded charge plate of the present invention with an associated ink jet printing head.

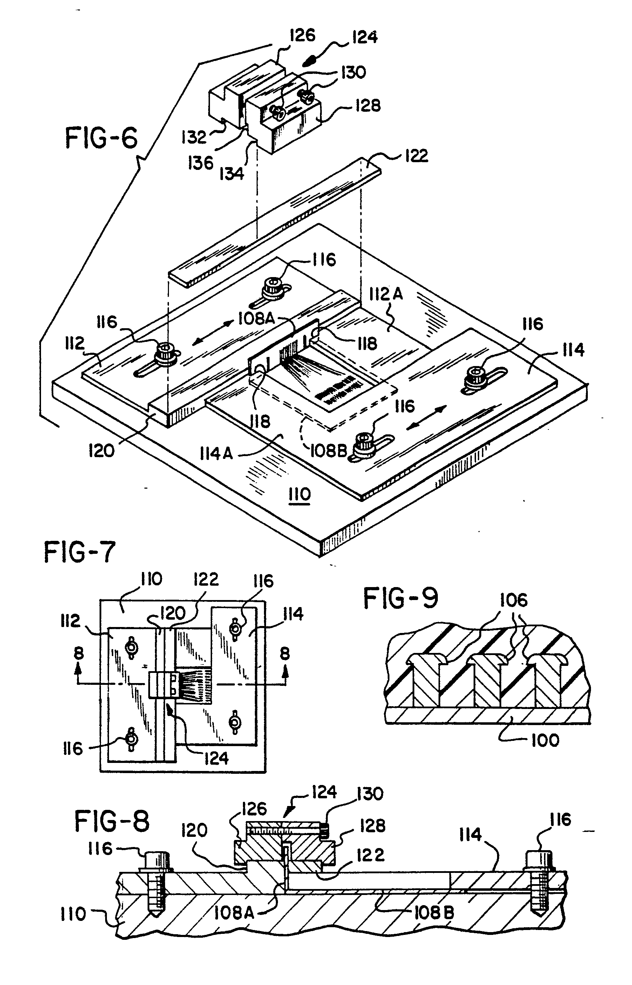

The composite foil sheet/plating 108 shown in Fig. 3 is then bent in a conventional manner toward the plated material electrodes and circuit paths to form an upwardly extending portion 108A and a horizontal portion 108B. For example, a bending die engages the plated side of the composite and bends the composite by forcing it into a resilient backing pad which engages the unplated side of the composite. The bend is formed such that at least a portion of the electrodes 106A are oriented at approximately 90°, 89° being preferred, relative to the remainder of the foil sheet containing the conducting circuit paths 106B. The bent composite 108 as shown in Fig. 5 is then placed into a mold, an illustrative embodiment of which is shown in Fig. 6.

Substantially evenly spaced "dummy" electrodes may be formed across the entire width of the foil sheet 100 as suggested by the dotted line electrodes 109 as shown in Fig. 3. Such dummy electrodes appear much the same as the alignment pins 107 but are spaced approximately the same as the electrodes 106A and extend from the outermost ones of the electrodes 106A substantially to the edges of the foil sheet 100. The formation of dummy electrodes provides a substantially uniform thickness for the composite foil sheet/plating 108 in the area to be bent and, hence, tends to enhance the yield of charge plates formed in accordance with the present invention.

Sheet means, for example, a perforated sheet of fiberglass epoxy board 111, can be inserted into the mold over the conducting circuit paths 106B and connecting points 106C as shown in phantom in Fig. 5. The board 111 displaces some of the epoxy to thereby reduce shrinkage of the epoxy during curing. The board 111 can be covered with an electrically conductive coating which in turn is connected to a selected potential, typically ground potential, via an otherwise isolated connecting point 111A. The grounded conducting covering reduces potential interference or cross-talk between the signals on the electrodes and connecting circuit paths.

Alternately, a perforated sheet of stainless steel, insulated from the circuit paths 106B and connecting points 106C can be used for epoxy displacement. The stainless steel sheet can also be utilized to reduce interference or cross talk by being connected to ground in a manner similar to that of the conductive coating on the fiberglass board as described above. Of course, a fiberglass, stainless steel or other appropriate epoxy displacement sheet also serves to strengthen the substrate and, hence, the charge plate of the present invention.

The mold as shown in Fig. 6 comprises a base plate 110 to which two mold forming, generally L-shaped members 112 and 114 are adjustably secured by bolts 116 to form a variety of mold sizes. While any suitable mold can be utilized in accordance with the present invention, the mold shown in Fig. 6 provides for clamping the horizontal portion 108B of the foil sheet 100 including the connecting paths 106B to the base plate 110 of the mold by initially moving the mold forming members 112 and 114 to their extreme extended positions and inserting the edges of the composite foil sheet/plating 108 under short extensions 112A and 114A of the L-shaped members 112 and 114. Slots 118 are formed in the short extensions 112A and 114A to accommodate the bent upwardly extending portion 108A of the foil sheet/plating composite 108. The slots 118 are not required if the upwardly extending portion 108A is initially clamped to the mold. Such initial clamping may be performed by alternate mold and/or clamp embodiments as would be apparent to one skilled in the art.

An upward extension 120 on the L-shaped member 112 provides for clamping the bent upwardly extending portion 108A of the composite 108 to ensure flatness of the substrate face into which the electrodes 106A will be embedded. A generally flat bar 122 is positioned upon the upper surface of the short extensions 112A and 114A of the L-shaped members 112 and 114 and is clamped to secure the bent upwardly extending portion 108A of the composite 108 against the upward extension 120 of the member 112. An illustrative clamp 124 is shown in Figs. 6, 7 and 8 although any form of clamp can be provided to maintain clamping pressure on the bar 122 or to substitute for the clamp 124 and the clamping bar 122.

The clamp 124 comprises first and second clamp members 126 and 128 which are secured to one another for clamping by bolts 130. The first clamp member 126 has a notch 132 for engaging the extension 120 and the second clamp member 128 has a notch 134 for engaging the bar 122. The second clamp member 128 also has a second notch 136 into which the bent upwardly extending portion 108A of the composite 108 can extend during the substrate molding operation.

A limited clamping pressure is desirable to prevent deformation of the clamped plating. It is noted, however, that the plating may be limited such that it does not extend to the portion of the foil sheet which is clamped. Further, any deformation may be trimmed away together with excess portions of the foil sheet after substrate molding.

Once the bent composite 108 is positioned and clamped within the mold, a casting resin is injected into the mold to form a dielectric substrate 138 (see Fig. 11) for the molded charge electrode structure. The casting resin should have a relatively low viscosity, exhibit little shrinkage upon curing, be relatively strong and physically stable.

One casting resin which has been found suitable is an epoxy resin comprising Bisphenol A and Epichlorohydrin which is sold by Emerson & Cuming, Inc. of Northbrook, Illinois, under the name STYCAST 2850FT. This resin is mixed by weight in a ratio of about 100 parts STYCAST 2850FT resin with 4 to 5 parts of a modified aliphatic amine catalyst such as identified by Emerson & Cuming, Inc. as CATALYST 11. Standard molding practices, release agents and air evacuation using vacuum are recommended for the molding process all of which are well known in the art and will not be described in detail herein. The filled mold is then cured at 100°C oven for approximately 2 hours.

After curing, the mold is taken apart, excess foil is trimmed away and the entire molded piece is immersed in a conventional etchant to remove the foil but not adversely effect the plating material or the substrate. Fragmentary sectional views of a small portion of the foil sheet 100 and three electrodes or circuit paths with three associated retaining flanges 106 embedded into the dielectric substrate 138 are shown before and after removal in Figs. 9 and 10, respectively.

The molded piece is then finished on the poured surface by conventional methods or alternatively, the mold may include an upper surface such that no further finishing is required. For example, the clamping bar 122 could be widened to extend over substantially the entire length of the mold cavity. It is to be understood that any molding process which will result in a dielectric substrate in which the electrodes and circuit paths and their retaining flanges are embedded may be utilized in accordance with the present invention.

It will be appreciated from an understanding of the above-described fabrication method of the present invention that the novel molded charge electrode structure formed by that method, as shown in Fig. 11, comprises a rugged, high reliability charge plate having high dimensional accuracy and excellent electrical characteristics which is inexpensively and readily fabricated by means of highly accurate photolithographic, plating and molding techniques without any requirement for high precision machining operations. The electrodes 106A and the connecting circuit paths 106B which terminate in connecting points 106C are three dimensional electroformed structures which are embedded into the dielectric substrate 138 and anchored into that substrate by means of internally engaged retaining flanges 106 best seen in Figs. 9 and 10. Further, the operations performed in accordance with the method of the present invention readily lend themselves to automated fabrication of the novel molded charge plates.

While the method herein described and the form of apparatus constructed in accordance with the method constitute preferred embodiments of this invention, it is to be understood that the invention is not limited to this precise method and form of apparatus and that changes may be made in either without departing from the scope of the invention as defined in the appended claims.

## Claims

1. A charge electrode structure comprising a dielectric substrate (138), a plurality of regularly spaced electrodes (106A) exposed at a first surface of said substrate (138), and a plurality of electrically conducting circuit paths (106B) disposed in a second surface of said substrate (138) adjacent to said first surface, said circuit paths (106B) being electrically connected to said electrodes (106A), characterised in that both said regularly spaced electrodes (106A) and said electrically conducting circuit paths (106B) are embedded within the respective first and second surfaces of said substrate.

2. A charge electrode structure as claimed in claim 1 wherein said electrodes (106A) include retaining means (106) for anchoring said embedded electrodes (106A) into said substrate (138).

3. A charge electrode structure as claimed in claim 2 wherein said circuit paths (106B) include retaining means (106) for anchoring said embedded circuit paths (106B) into said substrate (138).

4. A charge electrode structure as claimed in claim 3 wherein said electrodes (106A) and circuit paths (106B) comprise in cross-section generally parallel sidewalls extending into said substrate (138) and said retaining means (106) comprise expansions of said electrodes (106A) and circuit paths (106B) beyond said sidewalls at the innermost ends of said electrodes (106A) and circuit paths (106B).

5. A charge electrode structure as claimed in claim 4 wherein said dielectric substrate (138) comprises an epoxy resin molded to said electrodes (106A) and circuit paths (106B).

6. A charge electrode structure as claimed in claim 5 further comprising sheet means (111) embedded within said molded epoxy resin substrate (138) for reducing the required volume of said epoxy resin and strengthening said substrate (138).

7. A charge electrode structure as claimed in claim 6 wherein said sheet means comprises a laminated fiberglass epoxy board (111) which includes a layer of electrically conductive material formed thereon and further comprising means (111A) for connecting a selected potential to said electrically conductive layer whereby interference between signals conducted on said electrodes (106A) and circuit paths (106B) is reduced.

8. A charge electrode structure as claimed in claim 6 wherein said sheet means comprises a perforated sheet of stainless steel (111) and further comprising means (111A) for connecting a selected potential to said perforated sheet whereby the required volume of said epoxy resin is reduced, said substrate (138) is strengthened and interference between signals conducted on said electrodes (106A) and circuit paths (106B) is reduced.

9. A method of fabricating a charge electrode structure comprising the steps of:

forming a pattern (104) defining electrode (104A) and associated connecting circuit path (104) positions on a substantially planar foil sheet (100), the remainder of said sheet (100) being protected by a covering (102) and thereby being resistant to plating operations;

plating said pattern (104) with an electrically conducting material to form electrodes (106A) and associated connecting circuit paths (106B);

removing said covering (102) from said foil sheet (100);

bending said foil sheet (100) toward said plated material such that at least a portion of said electrodes (106A) are angularly oriented relative to said circuit paths (106B);

forming a dielectric substrate (138) surrounding said plated material with said foil sheet (100) remaining exposed at the surface of said substrate (138); and

removing said foil sheet (100) to expose plated material electrodes (106A) and associated connecting circuit paths (106B) embedded in the surface of said substrate (138).

10. A method of fabricating a charge electrode structure as claimed in claim 9 wherein said plating step comprises plating to a thickness exceeding the thickness of said covering (102) such that the plated material extends over the upper surface of said covering (102) to form retaining flanges (106) on each of said electrodes (106A) and circuit paths (106B), the lateral extension of said flanges (106) being limited such that no two of said flanges (106) interconnect whereby said electrodes (106A) and associating connecting circuit paths (106B) are anchored to said substrate (138) by means of said retaining flanges (106).

11. A method of fabricating a charge electrode structure as claimed in claim 10 further comprising the step of clamping the bent portion (108A) of said foil sheet (100) against a substantially flat surface prior to molding said substrate (138) to ensure substantial flatness of the surface of said substrate (138) including said plated material electrodes (106A).

12. A method of fabricating a charge electrode structure as claimed in claim 10 wherein the step of forming a pattern (104) defining electrode (104A) and associated connecting circuit path (104B) positions comprises the steps of:

laminating a covering (102) to a foil sheet (100), said covering (102) comprising a photoresistive film material;

exposing the covered side of said sheet (100) to actinic light through a photomask to define said pattern (104) on said covering (102); and

removing the portions of said covering (102) corresponding to said pattern (104) to expose said foil sheet (100) under said pattern (104).

13. A method of fabricating a charge electrode structure as claimed in claim 10 wherein the step of forming a dielectric substrate (138) comprises the steps of:

placing said foil sheet (100) into a mold with said foil sheet (100) effectively forming two walls of said mold; and

molding a dielectric substrate (138) in said mold, said substrate (138) extending to the surface of said foil sheet (100) to surround said plated material including said retaining flanges (106).

14. A method of fabricating a charge electrode structure as claimed in claim 13 further comprising the steps of:

clamping the portion (108B) of said sheet (100) including said circuit paths (106B) against the bottom wall of said mold to effectively form said bottom wall and to ensure substantial flatness of the corresponding side of said substrate (138); and

clamping the bent portion (108A) of said sheet (100) against a sidewall of said mold to effectively form said sidewall and to ensure substantial flatness of the surface of said substrate (138) including said plated material electrodes (106A).

15. A method of fabricating a charge electrode structure as claimed in claim 14 further comprising the step of placing perforated sheet means (111) over said circuit paths (106B) prior to forming said dielectric substrate (138) whereby said perforated sheet means (111) is embedded within and strengthens said substrate (138).

16. A method of fabricating a charge electrode structure as claimed in claim 14 further comprising the steps of placing a perforated sheet of fiberglass epoxy board (111) having an electrically conductive coating thereon over said circuit paths (106B) prior to forming said dielectric substrate (138) and providing means (111A) for connecting a selected potential to said electrically conductive coating whereby said substrate is strengthened and interference between signals conducted on said electrodes (106A) and said circuit paths (106B) is reduced.

17. A method of fabricating a charge electrode structure as claimed in claim 14 further comprising the steps of placing a perforated sheet (111) of stainless steel over said circuit paths (106B) and insulated therefrom prior to forming said dielectric substrate (138) and providing means (111A) for connecting a selected potential to said perforated sheet (111) whereby said substrate (138) is strengthened and interference between signals conducted on said electrodes (106A) and said circuit paths (106B) is reduced.

18. A method of fabricating a charge electrode structure comprising the steps of:

laminating a photoresistive covering (102) to a copper sheet (100);

exposing the covered side of said copper sheet (100) to actinic light through a photomask to impose a pattern (104) defining electrode (104A) positions and associated connecting circuit path (104B) positions on said covering;

developing said covering (102) to remove the portion of said covering (102) corresponding to said pattern (104) and expose said copper sheet (100) under said pattern (104) with the remainder of said covering (102) remaining intact and being resistant to plating operations;

plating said pattern (104) with nickel to form electrodes (106A) and associated connecting circuit paths (106B) of a thickness exceeding the thickness of said covering (102) such that the nickel extends above and over the upper surface of said covering (102) to form retaining flanges (106) on each of said electrodes (106A) and circuit paths (106B), the lateral extension of said flanges (106) being limited such that no two of said flanges (106) interconnect;

removing the remainder of said photoresistive covering (102) from said foil sheet (100);

bending a portion (108A) of said foil sheet (100) toward said plated material electrodes (106A) and circuit paths (106B) such that at least a portion of said electrodes (106A) are oriented at approximately a 90° angle relative to said circuit paths (106B);

placing said foil sheet (100) into a mold;

clamping the portion (108B) of said sheet (100) including said circuit paths (106B) into said mold to effectively form the bottom surface of said mold and to ensure substantial flatness of that portion of said sheet (100);

clamping the bent portion (108A) of said sheet (100) including a portion of said electrodes (106A) against a sidewall of said mold to effectively form the sidewall surface of said mold and to ensure substantial flatness of that bent portion (108A) of said sheet (100);

injecting an epoxy material into said mold, said epoxy material flowing to the surface of said foil sheet to surround said plated material electrodes (106A) and circuit paths (106B) including said retaining flanges (106);

curing said epoxy material to form a copper clad dielectric substrate (138) having said electrodes (106A) and circuit paths (106B) embedded therein and anchored thereto; and

immersing said copper clad dielectric substrate (138) into a copper etchant to remove said copper sheet (100) and thereby expose the plated material electrodes (106A) and connecting circuit paths (106B) on adjacent surfaces of said substrate (138).

19. A method of fabricating a charge electrode structure as claimed in claim 18 further comprising the step of placing a perforated sheet (111) of fiberglass epoxy board into said mold prior to injecting an epoxy material into said mold whereby said perforated sheet (111) is embedded within and strengthens said substrate (138).

20. A method of fabricating a charge electrode structure as claimed in claim 18 further comprising the steps of placing a perforated sheet (111) of fiberglass epoxy board having an electrically conductive coating thereon into said mold prior to injecting an epoxy material into said mold and providing means (111A) for connecting a selected potential to said electrically conductive coating whereby said substrate (138) is strengthened and interference between signals conducted on said electrodes (106A) and said circuit paths (106B) is reduced.

21. A method of fabricating a charge electrode structure as claimed in claim 18 further comprising the steps of placing a perforated sheet (111) of stainless steel insulated from said circuit paths (106B) into said mold prior to injecting an epoxy material into said mold and providing means (111A) for connecting a selected potential to said perforated sheet (111) whereby said substrate (138) is strengthened and interference between signals conducted on said electrodes (106A) and said circuit paths (106B) is reduced.

**Patentansprüche**

1. Ladeelektrodenaufbau mit einem dielektrischen Substrat (138), einer Mehrzal von gleichmäßig beabstandeten Elektroden (106A), welche an einer ersten Flächen des Substrates (138) freiliegen, und mit einer Mehrzahl von elektrisch leitenden Schaltkreispfaden (106B), welche in einer zweiten Oberfläche des Substrates (138) angeordnet sind, die der ersten Fläche benachbart ist, wobei die Schaltkreispfade (106B) mit den Elektroden (106A) elektrisch verbunden sind, dadurch gekennzeichnet, daß sowohl die gleichmäßig beabstandeten Elektroden (106A) als auch die elektrisch leitenden Schaltkreispfade (106B) in den entsprechenden ersten und zweiten Oberflächen des Substrates eingebettet sind.

2. Ladeelektrodenaufbau nach Anspruch 1, wobei die Elektroden (106A) Haltemittel (106) zum Verankern der eingebetteten Elektroden (106A) in dem Substrat (138) aufweisen.

3. Ladeelektrodenaufbau nach Anspruch 2, wobei die Schaltkreispfade (106B) Haltemittel (106) zum Verankern der eingebetteten Schaltkreispfade (106B) in dem Substrat (138) aufweisen.

4. Ladeelektrodenaufbau nach Anspruch 3, wobei die Elektroden (106A) und Schaltkreispfade (106B) im Querschnitt im wesentlichen parallele Seitenwände aufweisen, welche sich in das Substrat (138) hineinerstrecken und wobei die Haltemittel (106) Ausweitungen der Elektroden (106A) und der Schaltkreispfade (106B) über die Seitenwände hinaus an den am weitesten innenliegenden Enden der Elektroden (106A) und der Schaltkreispfade (106B) aufweisen.

5. Ladeelektrodenaufbau nach Anspruch 4, wobei das dielektrische Substrat (138) ein Epoxydharz aufweist, welches an die Elektroden (106A) und Schaltkreispfade (106B) angegossen ist.

6. Ladeelektrodenaufbau nach Anspruch 5, welcher weiterhin Plattenmittel (111) aufweist, welche in das geformte Epoxydharzsubstrat (138) eingebettet sind, um das erforderliche Volumen des Epoxydharzes zu reduzieren und das Substrat (138) zu verstärken.

7. Ladeelektrodenaufbau nach Anspruch 6, wobei die Plattenmittel eine Fiberglasepoxydplatte (111) mit Schichtstruktur aufweisen, welche eine Schicht von elektrisch leitendem Material aufweist, welche darauf ausgebildet ist und weiterhin Mittel aufweist zum Anschließen eines ausgewählten Potentials an die elektrisch leitende Schicht, wodurch eine gegenseitige Beeinflussung zwischen Signalen, die an die Elektroden (106A) und an die Schaltkreispfade (106B) geführt werden, reduziert wird.

8. Ladeelektrodenaufbau nach Anspruch 6, wobei das Plattenmittel eine perforierte Lage von rostfreiem Stahl (111) aufweist und weiterhin Mittel (111A) aufweist zum Anschluß eines ausgewählten Potentials an die perforierte Lage, wodurch das erforderliche Volumen von Epoxydharz reduziert wird, das Substrat (138) verstärkt wird und eine gegenseitige Beeinflussung zwischen Signalen, welche an die Elektroden (106A) und an die Schaltkreispfade (106B) geleitet werden, reduziert wird.

9. Verfahren zum Herstellen eines Ladeelektrodenaufbaus mit folgenden Schritten:

Bilden eines Musters (104), welches Elektroden- (104A) und zugehörige Anschlußschaltkreispfad- (104) lagen auf einem im wesentlichen ebenen Folienblatt (100) definieren, wobei der übrige Teil des Blattes (100) durch eine Abdeckschicht (102) geschützt wird und dadurch Plattierungsvorgängen widersteht;

Plattieren des Musters (104) mit einem elektrisch leitfähigen Material, um Elektroden (106A) und zugehörige verbindende Schaltkreispfade (106B) zu bilden;

Entfernen der Abdeckschicht (102) von dem Folienblatt (100);

Biegen bzw. Abknicken des Folienblattes (100) zu dem Plattierten Material hin, so daß zumindest ein Teil der Elektroden (106A) unter einem Winkel relativ zu den Schaltkreispfaden (106B) ausgerichtet ist;

Bilden eines dielektrischen Substrates (138), welches das plattierte Material umgibt, wobei das Folienblatt (100) an der Oberfläche des Substrates (138) offenliegt; und

Entfernen des Folienblattes (100), um die Elektroden (106A) aus plattiertem Material und die zugehörigen Verbindungsschaltkreispfade (106B), welche in die Oberfläche des Substrates (138) eingebettet sind, offenzulegen.

10. Verfahren zum Herstellen eines Ladeelektrodenaufbaus nach Anspruch 9, wobei der Plattierungsschritt ein plattieren auf eine Dicke einschließt, welche die Dicke der Abdeckschicht (102) übersteigt, so daß das plattierte Material sich über die obere Fläche der Abdeckschicht (102) hinaus erstreckt, um auf jeder Seite der Elektroden (106A) und der Schaltkreispfade (106B) Halteflansche (106) zu bilden, wobei die seitliche Erstreckung der Flansche (106) so begrenzt ist, daß sich keine der Flansche (106) miteinander verbinden, wodurch die Elektroden (106A) und die zugehörigen Anschlußschaltkreispfade (106B) an dem Substrat (138) über die Halteflansche (106) verankert werden.

11. Verfahren zum Herstellen eines Ladeelektrodenaufbaus nach Anspruch 10, welches weiterhin den Schritt aufweist, daß der gebogene Abschnitt (108A) des Folienblattes (100) vor dem Gießen bzw. Formen des Substrates (138) gegen eine im wesentlichen flache Oberfläche geklemmt wird, um eine im wesentlichen flache Form der Oberfläche des Substrates (138) einschließlich der Elektroden (106A) aus plattiertem Material sicherzustellen.

12. Verfahren zum Herstellen eines Ladeelektrodenaufbaus gemäß Anspruch 10, wobei der Schritt des Ausbildens eines Musters (104), welches Elektroden-, (104A) und zugehörige verbindende Schaltkreispfad- (104B) lagen definiert, die Schritte aufweist:

Laminieren einer Deckschicht (102) auf ein Folienblatt (100), wobei die Deckschicht ein Fotoresist-Filmmaterial aufweist;

die abgedeckte Seite des Blattes (100) aktinischem Licht durch eine Fotomaske aussetzen, um das Muster (104) auf der Abdeckschicht (102) festzulegen; und

Entfernen der Teile der Abdeckschicht (102), welche dem Muster (104) entsprechen, um das Folienblatt (100) unter dem Muster (104) offenzulegen.

13. Verfahren zum Herstellen eines Ladeelektrodenaufbaus gemäß Anspruch 10, wobei der Schritt des Ausbildens eines dielektrischen Substrates (138) folgende Schritte aufweist:

Anordnen des Folienblattes (100) in einer Form, wobei das Folienblatt (100) im Ergebnis zwei Wände der Form bildet; und

Gießen eines dielektrischen Substrates (138) in die Form, wobei sich das Substrat (138) bis zu der Oberfläche des Folienblattes (100) erstreckt, um das plattierte Material einschließlich der Halteflansche (106) zu umgeben.

14. Verfahren zum Herstellen eines Ladeelektrodenaufbaues nach Anspruch 13, welches weiterhin folgende Schritte aufweist:

Klemmen des Abschnittes (108B) des Blattes (100), welcher die Schaltkreispfade (106B) aufweist, gegen den Boden der Form, um wirksam die Bodenwand zu bilden und um sicherzustellen, daß die entsprechende Seite des Substrates (138) im wesentlichen flach ist, und

Klemmen des gebogenen Abschnittes (108A) des Blattes (100) gegen eine Seitenwand der Form, um wirksam die Seitenwand zu bilden und um sicherzustellen, daß die Oberfläche des Substrates (138), welche die Elektroden (106A) aus plattiertem Material aufweist, im wesentlichen flach ist.

15. Verfahren zum Herstellen eines Ladeelektrodenaufbaus nach Anspruch 14, welches weiterhin den Schritt aufweist, daß perforierte Blattmittel (111) vor dem Bilden des dielektrischen Substrates (138) über den Schaltkreispfaden (106B) angeordnet werden, wodurch die perforierten Blattmittel (111) in dem Substrat (138) eingebettet sind und dieses verstärken.

16. Verfahren zum Herstellen eines Ladeelektrodenaufbaus nach Anspruch 14, welches weiterhin die Schritte aufweist, daß ein perforiertes Blatt einer Fiberglasepoxydplatte (111), welches eine elektrisch leitfähige Beschichtung hat, vor dem Ausbilden des dielektrischen Substrates (138) über den Schaltkreispfaden (106B) angeordnet wird, und daß Mittel (111A) vorgesehen werden zum Anschluß eines ausgewählten Potentials an die elektrisch leitende Beschichtung, wodurch das Substrat verstärkt wird und die gegenseitige Beeinflussung zwischen Signalen, welche auf die Elektroden (106A) und auf den Schaltkreispfaden (106B) geleitet werden, reduziert wird.

17. Verfahren zum Herstellen eines Ladeelektrodenaufbaus nach Anspruch 14, welches weiterhin die Schritte aufweist, daß vor dem Ausbilden des dielektrischen Substrates (138) ein perforiertes Blatt (111) aus rostfreiem Stahl über den Schaltkreispfad (106B) angeordnet und von diesen isoliert wird und daß Mittel (111A) vorgesehen werden zum Anschluß eines ausgewählten Potentials an das perforierte Blatt (111), wodurch das Substrat (138) verstärkt wird und eine gegenseitige Beeinflussung zwischen Signalen, welche auf die Elektroden (106A) und auf den Schaltkreispfaden (106B) geleitet werden, reduziert wird.

18. Verfahren zum Herstellen eines Ladeelektrodenaufbaus mit den folgenden Schritten:

Laminieren einer Fotoresistabdeckung (102) auf ein Kupferblatt (100);

die abgedeckte Seite des Kupferblattes (100) durch eine Fotomaske aktinischem Licht aussetzen, um ein Muster (104) aufzuprägen, welches Elektroden- (104A) lagen und zugehörige verbindende Schaltkreispfad- (104B) lagen auf der Abdeckung festlegen;

Entwickeln der Abdeckung (102), um den Anteil der Abdeckung (102) zu entfernen, welcher dem Muster (104) entspricht und Offenlegen des Kupferblattes (100) unter dem Muster (104), wobei der verbleibende Teil der Abdeckschicht (102) intakt bleibt und Plattierungsvorgängen widersteht;

Plattieren des Musters (104) mit Nickel, um Elektroden (106A) und zugehörige verbindende Schaltkreispfade (106B) von einer Dicke zu bilden, welche die Dicke der Abdeckschicht (102) übersteigt, derart, daß das Nikkel sich nach oben und über die obere Oberfläche der Abdeckschicht (102) erstreckt, so daß Halteflansche (106) an jeder der Elektroden (106A) und Schaltkreispfade (106B) gebildet werden, wobei die seitliche Ausdehnung der Flansche (106) so begrenzt wird, daß keine zwei der Flansche (106) miteinander in Verbindung treten;

Entfernen der verbliebenen Fotoresistabdeckung (102) von dem Folienblatt (100);

Biegen eines Abschnittes (108A) des Folienblattes (100) in Richtung auf die Elektroden (106A) und Schaltkreispfade (106B) aus plattiertem Material derart, daß zumindest ein Teil der Elektroden (106A) unter einem Winkel von näherungsweise 90° relativ zu den Schaltkreispfaden (106B) ausgerichtet ist;

Anordnen des Folienblattes (100) in einer Form;

Einklemmen des Abschnittes (108B) des Blattes (100), welcher die Schaltkreispfade (106B) aufweist, in der Form, um in wirksamer Weise die Bodenfläche der Form zu bilden und um sicherzustellen, daß dieser Abschnitt des Blattes (100) im wesentlichen flach ist;

Klemmen des gebogenen Abschnittes (108A) des Blattes (100), welcher einen Teil der Elektroden (106A) einschließt, gegen eine Seitenwand der Form, um in wirksamer Weise die Seitenwandfläche der Form zu bilden und um sicherzustellen, daß dieser abgebogene Abschnitt (108A) des Blattes (100) im wesentlichen flach ist;

Einspritzen eines Epoxydmaterials in die Form, wobei das Epoxydmaterial auf die Oberfläche des Folienblattes fließt, um die Elektroden (106A) und Schaltkreispfade (106B) einschließlich der Halteflansche (106) zu umgeben;

Aushärten des Epoxydmaterials, um ein kupferplattiertes dielektrisches Substrat (138) zu bilden, in welchem die Elektroden (106A) und Schaltkreispfade (106B) eingebettet und verankert sind, und

Eintauchen des kupferplattierten dielektrischen Substrates (138) in ein Kupferätzmittel, um das Kupferblatt (100) zu entfernen und dadurch die Elektroden (106A) und verbindenden Schaltkreispfade (106B) aus plattiertem Material an den benachbarten Flächen des Substrates (138) offenzulegen.

19. Verfahren zum Herstellen eines Ladeelektrodenaufbaus nach Anspruch 18, welches weiterhin den Schritt aufweist, daß ein perforiertes Blatt (111) aus einer Fiberglasepoxydplatte vor dem Einspritzen des Epoxydmaterials in die Form in der Form angeordnet wird, wodurch das perforierte Blatt (111) in dem Substrat (138) eingebettet wird und dieses verstärkt.

20. Verfahren zum Herstellen eines Ladeelektrodenaufbaus nach Anspruch 18, welches weiterhin die Schritte aufweist, daß vor dem Einspritzen von Epoxydmaterial in die Form ein perforiertes Blatt (111) aus einer Fiberglasepoxydplatte, welche eine elektrisch leitfähige Beschichtung hat, in der Form angeordnet wird und daß Mittel (111A) für den Anschluß eines ausgewählten Potentials an die elektrisch leitfähige Beschichtung vorgesehen werden, wodurch das Substrat (138) verstärkt wird und die gegenseitige Beeinflussung zwischen auf die Elektroden (106A) und auf den Schaltkreisleitungspfaden (106B) geleiteten Signalen reduziert wird.

21. Verfahren zum Herstellen eines Ladeelektrodenaufbaus nach Anspruch 18, welches weiterhin die Schritte aufweist, daß vor dem Einspritzen von Epoxydmaterial ein perforiertes Blatt (111) aus rostfreiem Stahl, welches von den Schaltkreispfaden (106B) isoliert ist, in der Form angeordnet wird, und daß Mittel (111A) für den Anschluß eines ausgewählten Potentials an das perforierte Blatt (111) vorgesehen werden, wodurch das Substrat (138) verstärkt wird und eine gegenseitige Beeinflussung zwischen den Signalen, welche auf die Elektroden (106A) und auf den Schaltkreispfaden (106B) geleitet werden, reduziert wird.

## Revendications

1. Structure d'électrode de charge comprenant un substrat diélectrique (138), plusieurs électrodes (106A) régulièrement espacées exposées à une première surface dudit substrat (138), et plusieurs chemins (106B) de circuit conducteur de l'électricité disposés sur une seconde surface dudit substrat (138) adjacente à ladite première surface, lesdits chemins de circuit (106B) étant électriquement connectés auxdites électrodes (106A), caractérisée en ce que l'un et l'autre desdites électrodes régulièrement espacées (106A) et desdits chemins de circuit conducteur d'électricité (106B) sont encastrés à l'intérieur desdites première et seconde surfaces respectives dudit substrat.

2. Structure d'électrode de charge selon la revendication 1 dans laquelle lesdites électrodes (106A) comprennent des moyens de retenue (106) pour ancrer lesdites électrodes encastrées (106A) dans ledit substrat (138).

3. Structure d'électrode de charge selon la revendication 2 dans laquelle lesdits chemins de circuit (106B) comprennent des moyens de retenue (106) pour ancrer lesdits chemins de circuit encastrés (106B) dans ledit substrat (138).

4. Structure d'électrode de charge selon la revendication 3 dans laquelle lesdites électrodes (106A) et lesdits chemins de circuit (106B) comprennent en section transversale des parois latérales généralement parallèles s'étendant vers l'intérieur dudit substrat (138) et lesdits moyens de retenue (106) comprennent des excroissances desdites électrodes (106A) et desdits chemins de circuit (106B) au-delà desdites parois latérales aux extrémités intérieures desdites électrodes (106A) et desdits chemins de circuit (106B).

5. Structure d'électrode de charge selon la revendication 4 dans laquelle ledit substrat diélectrique (138) comprend une résine épary moulée sur lesdites électrodes (106A) et lesdits chemins de circuit (106B).

6. Structure d'électrode de charge selon la revendication 5 comprenant en outre un moyen de feuille (111) noyé à l'intérieur dudit substrat (138) en résine épary moulée pour réduire le volume nécessaire de ladite résine épary et renforcer ledit substrat (138).

7. Structure d'électrode de charge selon la revendication 6 dans laquelle ledit moyen de feuille comprend une plaque (111) laminée d'épary et de fibre de verre qui inclut une couche de matériau conducteur de l'électricité formée à sa surface et comprenant en outre un moyen (111A) pour connecter un potentiel choisi sur ladite couche conductrice de l'électricité de façon à réduire l'interférence entre les signaux conduits sur lesdites électrodes (106A) et lesdits chemins de circuit (106B).

8. Structure d'électrode de charge selon la revendication 6 dans laquelle ledit moyen de feuille comprend une feuille perforée d'acier inoxydable (111), et comprenant en outre des moyens (111A) pour connecter un potentiel choisi à ladite feuille perforée de façon à réduire le volume de ladite résine épary, à renforcer ledit substrat (138) et à réduire l'interférence entre les signaux conduits sur lesdites électrodes (106A) et lesdits chemins de circuit (106B).

9. Procédé de fabrication d'une structure d'électrode de charge comprenant les étapes de:
former un modèle (104) définissant les positions d'électrode (104A) et de chemin de circuit de connexion associé (104) sur une feuille sensiblement plane (100), le reste de ladite feuille (100) étant protégé par une couverture (102) et étant ainsi résistant aux opérations de plaquage;
plaquer ledit modèle (104) avec un matériau conducteur de l'électricité pour former les électrodes (106A) et les chemins de circuit de connexion associés (106B);
enlever ladite couverture (102) à l'écart de ladite feuille (100);
replier ladite feuille (100) en direction dudit matériau plaqué de telle sorte qu'au moins une portion desdites électrodes (106A) est orientée angulairement par rapport auxdits chemins de circuit (106B);
former un substrat diélectrique (138) entourant ledit matériau plaqué avec ladite feuille (100) restant exposée à la surface dudit substrat (138); et
enlever ladite feuille (100) pour expoaer les électrodes en matériau plaqué (106A) et les chemins de circuit de connexion associés (106B) encastrés dans la surface dudit substrat (138).

10. Procédé de fabrication d'une structure d'électrode de charge selon la revendication 9 dans lequel ladite étape de plaquage comprend le plaquage selon une épaisseur excédant l'épaisseur de ladite couverture (102) de telle sorte que le matériau plaqué s'étend au-dessus de la surface supérieure de ladite couverture (102) pour former des bourrelets de retenue (106) sur chacune desdites électrodes (106A) et chacun desdits chemins de circuit (106B), l'extension latérale desdits bourrelets (106) étant limitée de telle sorte qu'aucun couple desdits bourrelets (106) n'est interconnecté de sorte que lesdites électrodes (106A) et lesdits chemins de circuit de connexion associés (106B) sont ancrés dans ledit substrat (138) au moyen desdits bourrelets de retenue (106).

11. Procédé de fabrication d'une structure d'électrode de charge selon la revendication 10 comprenant en outre l'étape de fixer la portion repliée (108A) de ladite feuille (100) contre une surface sensiblement plate avant de mouler ledit substrat (138) pour réaliser sensiblement la planéité de la surface dudit substrat (138) comprenant lesdites électrodes en matériau de métallisation (106A).

12. Procédé de fabrication d'une structure d'électrode de charge selon la revendication 10 dans laquelle l'étape de formation d'un modèle (104) définissant les positions d'électrode (104A) et de chemin de circuit de connexion associé (104B) comprend les étapes:

plaquer une couverture (102) sur une feuille (100) ladite couverture (102) comprenant un film de matériau photorésistif;

exposer le côté couvert de ladite feuille (100) à une lumière actinique à travers un masque optique pour définir ledit modèle (104) sur ladite couverture (102); et

enlever les portions de ladite couverture (102) correspondant audit modèle (104) pour exposer ladite feuille (100) selon ledit modèle (104).

13. Procédé de fabrication d'une structure d'électrode de charge selon la revendication 10 dans lequel l'étape de former un substrat diélectrique (138) comprend les étapes de:

placer ladite feuille (100) dans un moule avec ladite feuille (100) formant effectivement deux murs dudit moule; et

mouler un substrat diélectrique (138) dans ledit moule, ledit substrat (138) s'étendant jusqu'à la surface de ladite feuille (100) pour entourer ledit matériau de métallisation y compris lesdits bourrelets de retenue (106).

14. Procédé de fabrication d'une structure d'électrode de charge selon la revendication 13 comprenant en outre les étapes de:

fixer la portion (108B) de ladite feuille (100) comprenant lesdits chemins de circuit (106B) contre la paroi de fond dudit moule pour former effectivement ladite paroi de fond et pour assurer sensiblement la planéité du côté correspondant dudit substrat (138); et

fixer la portion repliée (108A) de ladite feuille (100) contre une paroi de côté dudit moule pour former effectivement ladite paroi de côté et pour assurer sensiblement la planéité de la surface dudit substrat (138) comprenant lesdites électrodes (106A) en matériau de plaquage.

15. Procédé de fabrication d'une structure d'électrode de charge selon la revendication 14 comprenant en outre l'étape de placer un moyen de feuille perforée (111) au-dessus desdits chemins de circuit (106B) avant de former ledit substrat diélectrique (138) de sorte que ledit moyen de feuille perforée (111) est noyé à l'intérieur dudit substrat (138) et le renforce.

16. Procédé de fabrication d'une structure d'électrode de charge selon la revendication 14 comprenant en outre les étapes de placer une feuille perforée en plaque d'époxy et de fibre de verre (111) recouverte d'un enrobage conducteur de l'électricité par dessus lesdits chemins de circuit (106B) avant de former ledit substrat diélectrique (138) et prévoir un moyen (111A) pour connecter un potentiel choisi audit enrobage conducteur de l'électricité, de façon à renforcer ledit substrat et à réduire l'interférence entre les signaux conduits sur lesdites électrodes (106A) et lesdits chemins de circuit (106B).

17. Procédé de fabrication d'une structure d'électrode de charge selon la revendication 14 comprenant en outre l'étape de placer une feuille perforée (111) d'acier inoxydable au-dessus desdits chemins de circuit (106B) et de manière isolée par rapport à eux avant de former ledit substrat diélectrique (138) et prévoir un moyen (111A) pour connecter un potentiel choisi à ladite plaque perforée (111), de façon à renforcer ledit substrat (138) et à réduire l'interférence entre les signaux conduits sur lesdites électrodes (106A) et lesdits chemins (106B) de circuit.

18. Procédé de fabrication d'une structure d'électrode de charge comprenant les étapes de:

plaquer une couverture photorésistive (102) sur une feuille de cuivre (100);

exposer le côté recouvert de ladite feuille de cuivre (100) à une lumière actinique à travers un masque optique pour imposer un modèle (104) définissant les positions d'électrode (104A) et les positions de chemin de circuit de connexion associé (104B) sur ladite couverture;

développer ladite couverture (102) pour enlever la portion de ladite couverture (102) correspondant audit modèle (104) et exposer ladite feuille de cuivre (100) selon ledit modèle (104) avec le reste de ladite couverture (102) restant intacte et étant résistant aux opérations de plaquage;

plaquer ledit modèle (104) avec du nickel pour former des électrodes (106A) et des chemins de circuit de connexion associés (106B) selon une épaisseur excédant l'épaisseur de ladite couverture (102) de telle sorte que le nickel dépasse au-dessus et recouvre la surface supérieure de ladite couverture (102) pour former des bourrelets de retenue (106) sur chacune desdites électrodes (106A) et desdits chemins de circuit (106B), l'extension latérale desdits bourrelets (106) étant limitée de telle sorte qu'aucun couple desdits bourrelets (106) n'est interconnecté;

enlever ce qui reste de ladite couverture photorésistive (102) à l'écart de ladite feuille (100);

replier une portion (108A) de ladite feuille (100) en direction desdites électrodes en matériau de plaquage (106A) et desdits chemins de circuit (106B) de telle sorte qu'au moins une portion desdites électrodes (106A) est orientée selon approximativement un angle de 90° par rapport auxdits chemins de circuit (106B);

placer ladite feuille (100) dans un moule;

fixer la portion (108B) de ladite feuille (100) comprenant lesdits chemins de circuit (106B) dans ledit moule pour former effectivement la surface de fond dudit moule et pour réaliser sensiblement la planéité de cette portion de ladite feuille (100);

fixer la portion repliée (108A) de ladite feuille (100) comprenant une portion desdites électrodes (106A) contre une paroi latérale dudit moule pour former effectivement la surface laté-

rale dudit moule et pour réaliser sensiblement la planéité de cette portion repliée (108A) de ladite feuille (100);

injecter un matériau époxy dans ledit moule, ledit matériau époxy s'écoulant jusqu'à la surface de ladite feuille pour entourer lesdites électrodes en matériau de plaquage (106A) et lesdits chemins de circuit (106B) y compris lesdits bourrelets de retenue (106);

travailler ledit matériau époxy pour former un substrat (138) diélectrique habillé de cuivre ayant lesdites électrodes (106A) et lesdits chemins de circuit (106B) encastrés à l'intérieur et ancrés; et

immerger ledit substrat (138) diélectrique habillé de cuivre dans de l'eau forte pour cuivre pour enlever ladite feuille de cuivre (100) et exposer ainsi les électrodes en matériau de plaquage (106A) et lesdits chemins de circuit de connexion (106B) sur les surfaces adjacentes dudit substrat (138).

19. Procédé de fabrication d'une structure d'électrode de charge selon la revendication 18 comprenant en outre l'étape de placer une feuille perforée (111) en plaque d'époxy et de fibre de verre dans ledit moule avant d'injecter le matériau époxy dans ledit moule de sorte que ladite feuille perforée (111) est noyée à l'intérieur dudit substrat (138) et le renforce.

20. Procédé de fabrication d'une structure d'électrode de charge selon la revendication 18 comprenant en outre les étapes de placer une feuille perforée (111) en plaque d'époxy et de fibre de verre recouverte d'un enrobage conducteur de l'électricité à l'intérieur dudit moule avant d'injecter le matériau époxy dans ledit moule et prévoir un moyen (111A) pour connecter un potentiel choisi audit enrobage conducteur d'électricité de sorte que ledit substrat (138) est renforcé et l'interférence entre les signaux conduits sur lesdites électrodes (106A) et lesdits chemins de circuit (106B) est réduite.

21. Procédé de fabrication d'une structure d'électrode de charge selon la revendication 18 comprenant en outre les étapes de placer une feuille perforée (111) d'acier inoxydable isolée desdits chemins de circuit (106B) dans ledit moule avant d'injecter le matériau époxy dans ledit moule et prévoir un moyen (111A) pour connecter un potentiel choisi à ladite feuille perforée (111) de façon que ledit substrat (138) soit renforcé et que l'interférence entre les signaux conduits sur les électrodes (106A) et lesdits chemins de circuit (106B) soit réduite.

FIG-2A

106   102
105   100

FIG-I

104 B

102

100

104A

2

104

2

FIG-2

105   102

105   100

EP 0 132 972 B1

FIG-4

FIG-3

106C

106B

108

107

4

106A

106

107

109

4

106

100

EP 0 132 972 B1

FIG-5

FIG-IO

FIG-II

EP 0 132 972 B1

3

FIG-6

126    124
130
128
132
136    134
122

116
112 A
116
108A
118
112
118
114
116
120    114A    108B
110

FIG-7

110    122    116
112    120    114
8    8
116    124

FIG-9    106
100

FIG-8    124    130
126    128
120    122
116    116
110    108A    108B    114

4